Europäisches Patentamt

European Patent Office

Office européen des brevets

(19)

(11) Veröffentlichungsnummer: **0 158 727**

A1

(12) **EUROPÄISCHE PATENTANMELDUNG**

(21) Anmeldenummer: 84115542.7

(22) Anmeldetag: 15.12.84

(51) Int. Cl.⁴: **G 01 R 19/08**

(30) Prioritat 22.03.84 DE 3410875

(43) Veröffentlichungstag der Anmeldung:
23.10.85 Patentblatt 85/43

(84) Benannte Vertragsstaaten:
DE FR GB

(71) Anmelder: SCHERING AKTIENGESELLSCHAFT Berlin
und Bergkamen
Müllerstrasse 170/178 Postfach 65 03 11
D-1000 Berlin 65(DE)

(72) Erfinder: Rolff, Rolf
Brennersried 5
D-8371 Drachelsried/Bayern(DE)

(72) Erfinder: Nitsche, Detlev
General-Woyna-Strasse 38
D-1000 Berlin 51(DE)

(54) Verfahren zur Messung der Stromdichte in Galvanikbädern.

(57) Die Erfindung betrifft ein Verfahren zur Messung der Stromdichte in Galvanikbädern während des Galvanisiervorgangs, insbesondere bei der Plattierung von Leiterplatten, dadurch gekennzeichnet, daß die Messung direkt auf der Oberfläche der zu galvanisierenden Ware erfolgt, indem der Strom zwischen der Ware und einer auf deren Oberfläche isoliert angebrachten Metallinsel gemessen wird.

EP 0 158 727 A1

Die Erfindung betrifft ein Verfahren zur Messung der Stromdichte in Galvanikbädern während des Galvanisiervorgangs gemäß Oberbegriff des Anspruchs 1.

Beim Betrieb von Galvanikbädern können viele Fehlerquellen auftreten, die eine unbefriedigende Abscheidung aufgrund einer mangelhaften Stromdichteverteilung im Bad verursachen. Als solche Fehlerquellen gelten unter anderen ungenügender Anodenkontakt, falsch gewählte Streublenden, unzulängliche Warenbewegung und ungleichmäßige Lufteinblasung. Bisher ist eine Beseitigung dieser Fehlerquellen erst nach aufwendigem Einfahren der Bäder und Kontrolle der Ware nach erfolgter Galvanisierung möglich.

Aufgabe der vorliegenden Erfindung ist die Schaffung eines Verfahrens zur Messung der Stromdichte schon während des Galvanisiervorgangs, um derart eventuelle Fehlerquellen kurzfristig feststellen und vor Abschluß der Galvanisierung beseitigen zu können.

Diese Aufgabe wird erfindungsgemäß durch den in den Ansprüchen gekennzeichneten Gegenstand gelöst.

Durch dieses Verfahren wird die Messung der Stromdichten an einer Vielzahl von Warenteilen an allen gewünschten Stellen des Bades während seines Betriebes ermöglicht, so daß eventuelle Fehlerquellen sofort ermittelt und abgestellt werden können.

Beispielsweise lassen sich in einem Verkupferungsbad zur Beschichtung von Leiterplatten mehr als 100 Stellen gleichzeitig abfragen, indem die gegebenenfalls unterschiedlichen Spannungen zu einer gemeinsamen Schaltstelle geführt werden.

Es versteht sich, daß aus den einzelnen Spannungswerten die Stromdichte bekanntermaßen berechnet werden muß.

Vor Durchführung des erfindungsgemäßen Verfahrens ist eine Eichung der hierfür benötigten Vorrichtungen zweckmäßigerweise erforderlich.

‑3‑

Postanschrift: Schering Aktiengesellschaft, Postfach 65 03 11, D-1000 Berlin 65 · Für Besucher: Berlin-Wedding, Müllerstraße 170 178 Telegramme Scheringchemie Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats Hans-Jürgen Hamann Sitz der Gesellschaft: Berlin und Bergkamen   Handelsregister: AG Charlottenburg 93 HRB 283 und AG Kamen HRB 0061   Berliner Commerzbank AG, Berlin Konto-Nr 108700600, Bankleitzahl 100 400 00 · Berliner Handels- und Frankfurter Bank Berlin Konto-Nr 70045224 Bankleitzahl 100 202 00   Deutsche Bank Berlin AG Konto-Nr 2415008 Bankleitzahl 100 700 00  Postscheckamt Berlin West Konto-Nr 1175-101, Bankleitzahl 100 100 10

# P A T E N T A N S P R Ü C H E

1. Verfahren zur Messung der Stromdichte in Galvanikbädern während des galvanisiervorgangs, insbesondere bei der Plattierung von Leiterplatten, dadurch gekennzeichnet, daß die Messung direkt auf der Oberfläche der zu galvanisierenden Ware erfolgt, indem der Strom zwischen der Ware und einer auf deren Oberfläche isoliert angebrachten Metallinsel gemessen wird.

2. Verfahren gemäß Anspruch 1, dadurch gekennzeichnet, daß die Messung mittels eines außerhalb des Bades angebrachten Voltmeters erfolgt, das über isolierte Drähte mit den Enden eines isolierten Metalldrahtes verbunden ist, der die Oberfläche der Ware mit der Metallinsel verbindet.

3. Verfahren gemäß Anspruch 1, dadurch gekennzeichnet, daß die Messung an mehreren Stellen des Bades durchgeführt wird.

4. Vorrichtung zur Messung der Stromdichte gemäß den Ansprüchen 1 bis 3.

Postanschrift: Schering Aktiengesellschaft, Postfach 65 03 11, D-1000 Berlin 65 · Für Besucher Berlin-Wedding. Müllerstraße 170-178 · Telegramme. Scheringchem

Vorstand: Dr Herbert Asmis Dr Christian E John Dr Heinz Hannse Horst Kramp. Dr Klaus Pohle Dr Horst Witzel  Vorsitzender des Aufsichtsrats: Hans-Jürgen Sitz der Gesellschaft Berlin und Bergkamen Handelsregister AG Charlottenburg 93 HRB 283 und AG Kamen HRB 0061  Berliner Commerzbank AG. Berlin, K

**0158727**

Nummer der Anmeldung

EP 84 11 5542

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | GB-A- 832 182 (THE ENGLISH ELECTRIC COMPANY LTD.) * Seite 1, Zeilen 49-54,64-78; Seite 2, Zeilen 1-36; Ansprüche; Figuren 1,2 * | 1,3 | G 01 R 19/08 |
| A | | 4 | |
| A | GB-A-1 010 799 (THOMPSON RAMO WOOLDRIDGE INC.) * Figuren 1,2 * | 3 | |
| A | DE-C-1 128 035 (WILLY HUBER) | | |

---

RECHERCHIERTE SACHGEBIETE (Int Cl 4)

C 01 R
C 25 D
H 05 K

Der vorliegende Recherchenbericht wurde für alle Patentansprüche erstellt.

| Recherchenort DEN HAAG | Abschlußdatum der Recherche 20-06-1985 | Prüfer KAUFFMANN J. |
|---|---|---|